# EUROPEAN PATENT APPLICATION

(11) **EP 2 680 297 A1**
(43) Date of publication of application: **01.01.2014**
(21) Application number: 12749395.5
(22) Date of filing: 14.02.2012
(51) Int. Cl.: H01L 21/225, H01L 21/31, H01L 21/316, H01L 31/04

(54) **FILM FORMING METHOD AND FILM FORMING DEVICE**

(30) Priority: 21.02.2011 JP 2011034440
(71) Applicant: Sankei Engineering Co., Ltd., Yokohama-shi, Kanagawa 222-0033 (JP)
(72) Inventor: HONMA, Koji, Yokohama-shi, Kanagawa 222-0033 (JP); INUZUKA, Hitoshi, Yokohama-shi, Kanagawa 222-0033 (JP)
(74) Representative: Klunker . Schmitt-Nilson . Hirsch
(86) International application number: PCT/JP2012/053356
(87) International publication number: WO 2012/114935

(57) **Abstract**

This is to provide a film forming method, etc., which can form a film containing a high concentration of an impurity under atmospheric pressure efficiently without using a harmful and poisonous gas.

The film forming method is constituted by heating a solid source such as boron and phosphorus pentaoxide, etc., and evaporating to generate a gas, and the obtained gas is jetted to the surface(s) of a preheated substrate to form a film.

## Description

### TECHNICAL FIELD

The present invention relates to a method for forming a film containing impurities, for example, to diffuse impurities such as boron, phosphorus, etc., to a silicon substrate in the manufacturing process of a solar cell or a semiconductor and a device thereof.

### BACKGROUND ART

In the manufacturing process of, for example, a solar cell or a semiconductor, various kinds of techniques to diffuse impurities such as boron, phosphorus, etc., have been proposed to form a PN junction to a silicon substrate.
In the case of forming a diffusion layer of either of a P type or an N type, it has been well known that a film containing impurities is required to be formed, and various proposals have been done on the method for forming the film or the material of the impurity layer, etc.
For example, as a technique to form a P type diffusion layer, it has been known a method in which monosilane (SiH₄) and diborane (B₂H₆) are thermally decomposed under atmospheric pressure to form a boron oxide film (BSG) of a substrate (APCVD), or a method in which a boron oxide film (BSG) is formed on a substrate in an apparatus with a reduced pressure using plasma, thereafter a silicon oxide film (SiO₂, NSG) is formed as a cap layer, and a diffusion layer is formed under high temperature.

Also, as a technique for forming an N type diffusion layer, it has been known a method in which monosilane (SiH₄) and phosphine (PH₃) are thermally decomposed under atmospheric pressure to form a phosphorus oxide film (PSG) on a substrate, or a method in which a phosphorus oxide film (PSG) is formed on a substrate in an apparatus with a reduced pressure using plasma, then, the same cap layer as mentioned above is formed, and a diffusion layer is formed under high temperature.

In either of the formations of the diffusion layers, it has been well known that film formation including impurities is necessary, and various proposals have been made about a film forming method thereof or a material of an impurity, etc.
Also, for the purpose of simplification of the steps or reduction of the manufacturing cost, etc., it has been proposed a direct doping method using plasma, a continuous film forming method using thermal reaction in place of the plasma, or a method in which a paste or a solution containing an impurity is coated and heated to obtain an impurity-containing diffusion layer.

### PRIOR ART DOCUMENT

### PATENT DOCUMENT

[Patent document 1] JP 2010-161317A
[Patent document 2] JP 2010-056465A
[Patent document 3] JP 2009-253127A
[Patent document 4] JP 2009-246214A
[Patent document 5] JP 2009-147070A
[Patent document 6] JP 2008-282921 A

### SUMMARY OF THE INVENTION

### PROBLEM TO BE SOLVED BY THE INVENTION

In recent years, the spread of the power generating system using a solar cell has been rapidly progressed, and improvement in power generating efficiency has been desired. However, it is actually important that inexpensive solar cell panels are installed with a large amount for securing immediate electric power generation.
Here, for supplying a solar cell panel with an inexpensive cost, it is needless to say that to shorten manufacturing lead time and to make the manufacturing facilities low cost are urgent matter, in particular, it is useful to simplify the film forming device and film forming step of the impurity layer which are manufacturing means to form a conventional PN junction.

As in the prior art technique mentioned above, when an impurity layer for diffusion is formed by using plasma, vacuum facilities or high frequency facilities are required as a film forming device, so that the facilities themselves become expensive. Also, the film forming rate mainly depends on a flow amount of a source gas for film formation, but under the reduced conditions, it is difficult to introduce a large amount of the source gas, which causes elongation of the time of the film forming step and leads increase in the manufacturing cost. Moreover, the vacuum facilities cannot perform a continuous treatment and necessarily become a batch system treatment, whereby productivity can be difficultly improved.

To the contrary, when the APCVD treatment is to be carried out using monosilane (SiH₄), diborane (B₂H₆) and phosphine (PH₃) as source gases under atmospheric pressure, these gases are classified to dangerous gases having explosive and combustible properties and toxicity, etc. For using these gases, restriction and safety facilities are imposed, and it is essential to include an introduction cost of incidental facilities for keeping the facilities themselves.

Moreover, when a diffusion layer is to be obtained by dropping a solution or a paste containing boron in the case of the P type, or phosphorus in the case of the N type on a substrate, then coating them by a spin or an ink-jet system print, etc., and heating, but in the spin system, almost all the chemical solution are disposed without utilizing the same so that this is not efficient. In addition, these impurities are contained in the solvent in a particulate state, so that a small-sized nozzle of a printer head for an ink-jet printing is clogged whereby it is not suitable for a mass production step such as the manufacture of the solar cell.
Incidentally, various problems concerning the manufacture of the solar cell as mentioned above are also applied to the manufacture of the semiconductor device.

In view of the above-mentioned problems, an object of the present invention is to provide a film forming method and a film forming device, which do not use any harmful and poisonous gas, and can form a film containing an impurity with a high concentration(s) under atmospheric pressure efficiently.

### MEANS TO SOLVE THE PROBLEMS

The present invention is to solve the above-mentioned problems by the following solving means.
The invention according to Claim 1 is a film forming method which comprises heating a solid source of an impurity and vaporizing the same to generate a gas, and jetting the gas to a substrate whereby forming a film containing the impurity on the substrate.

The invention according to Claim 2 is the film forming method described in Claim 1, wherein the substrate is preheated before jetting the gas.

The invention according to Claim 3 is the film forming method described in Claim 1 or Claim 2, wherein the solid source is located in an apparatus having injection holes, and the gas generated by heating the solid source in the apparatus is jetted from the injection holes onto the substrate.

The invention according to Claim 4 is the film forming method described in Claim 3, wherein a carrier gas for carrying the gas into the apparatus is introduced, and the gas is jetted from the injection holes with the carrier gas.

The invention according to Claim 5 is the film forming method described in any one of Claim 1 to Claim 4, wherein the gas is jetted onto the substrate which is continuously conveyed by a conveying device.

The invention according to Claim 6 is the film forming method described in any one of Claim 1 to Claim 5, wherein diffusion of the impurity into the substrate is carried out by utilizing a temperature of the gas simultaneously with the formation of the film.

The invention according to Claim 7 is the film forming method described in any one of Claim 1 to Claim 6, wherein the solid source contains boron.

The invention according to Claim 8 is the film forming method described in any one of Claim 1 to Claim 6, wherein the solid source contains phosphorus oxide.

The invention according to Claim 9 is a film forming device which comprises a heating means to heat a solid source of an impurity and evaporate the same to generate a gas, and a jetting means to form a film containing the impurity onto a substrate by jetting the gas onto the substrate.

The invention according to Claim 10 is the film forming device described in Claim 9, wherein the device has a preheating means to preheat the substrate before jetting the gas.

The invention according to Claim 11 is the film forming device described in Claim 9 or Claim 10, wherein a container portion for containing the solid source is installed, the heating means is located at an inside of the container portion, and the jetting means is jetting holes formed to the container portion.

The invention according to Claim 12 is the film forming device described in Claim 11, wherein a carrier gas introducing means to introduce the carrier gas for carrying the gas into the container portion is installed, and the injection holes are to jet the gas with the carrier gas.

The invention according to Claim 13 is the film forming device described in any one of Claim 9 to Claim 12, wherein the jetting means has a conveying means to continuously convey the substrate.

The invention according to Claim 14 is the film forming device described in any one of Claim 9 to Claim 13, wherein diffusion of the impurity into the substrate is carried out by utilizing a temperature of the gas simultaneously with the formation of the film.

The invention according to Claim 15 is the film forming device described in any one of Claim 9 to Claim 14, wherein the solid source contains boron.

The invention according to Claim 16 is the film forming device described in any one of Claim 9 to Claim 14, wherein the solid source contains phosphorus oxide.

### EFFECTS OF THE INVENTION

According to the present invention, film formation can be carried out without using a toxic gas having high risk, for example, monosilane (SiH₄), diborane (B₂H₆), phosphine (PH₃), etc., so that safety of the device is high, incidental facilities such as a preventing facility for treatment obstacles, etc., are not necessary, whereby it can be expected to obtain an effect that a cost itself of the solar cell panel can be reduced.
Also, a film into which an impurity is diffused with a high density can be formed, so that it can be expected to obtain the effects that the treatment time of the film formation can be shortened and the treatment time of the wet processing necessary for removal of the film can be shortened.
Further, film formation and diffusion can be carried out simultaneously without using a diffusing device, so that it is possible to simplify the manufacturing process.
Incidentally, substantially the same effects can be obtained not only in a solar cell panel, but also in a semiconductor.

### BRIEF DESCRIPTION OF THE DRAWINGS

Fig. 1 is a drawing showing the constitution of the first embodiment of the film forming device to which the present invention has been applied.
Fig. 2 is a graph showing SIMS profile data of the silicon substrate of Example 1 in which film formation is carried out by the film forming device of the embodiment 1, and then, diffusion treatment is carried out.
Fig. 3 is a graph showing SIMS profile data of the silicon substrate of Example 2 in which film formation is carried out by the film forming device of the embodiment 1, and then, diffusion treatment is carried out.
Fig. 4 is a drawing showing the constitution of the second embodiment of the film forming device to which the present invention has been applied.
Fig. 5 is a drawing showing the constitution of the third embodiment of the film forming device to which the present invention has been applied.
Fig. 6 is a drawing showing the constitution of the fourth embodiment of the film forming device to which the present invention has been applied.

### EMBODIMENT TO CARRY OUT THE INVENTION

In the following, embodiments of the film forming method and the film forming device to which the present invention has been applied are explained by referring to the drawings, etc.
The film forming method and the film forming device of each embodiment are, for example, to form films containing boron or phosphorus which are impurities, on the both surfaces of the silicon substrate, respectively, in the manufacturing process of the solar cell panel or the semiconductor.
For forming an N type diffusion layer, after forming a film containing boron, a silicon substrate is heated, for example, to 800 to 1100°C under oxygen or nitrogen atmosphere to diffuse boron thereinto.
Also, for forming a P type diffusion layer, after forming a film containing phosphorus, a silicon substrate is heated, for example, to 800 to 1000°C under oxygen or nitrogen atmosphere to diffuse phosphorus thereinto.
Incidentally, at the time of the diffusion, a cap layer comprising, for example, SiO₂, etc., may be formed.

### <First embodiment>

In the following, a first embodiment of a film forming device to which the present invention has been applied is explained.

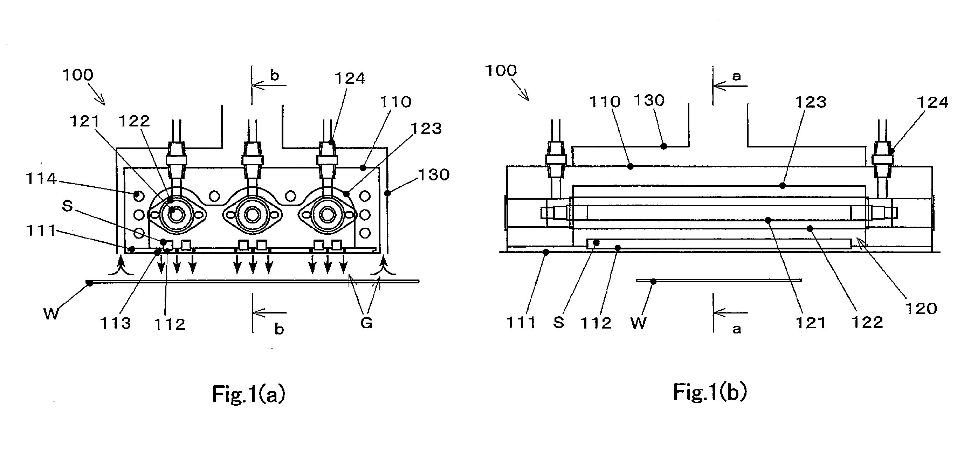

Fig. 1 is a drawing showing the constitution of the first embodiment of the film forming device, Fig. 1(a) is an arrow direction sectional view at the a-a portion of Fig. 1(b), and Fig. 1(b) is an arrow direction sectional view at the b-b portion of Fig. 1(a).
The film forming device 100 is constituted by having a vaporizing apparatus 110, a heating device 120, a discharging device 130, etc.

The vaporizing apparatus 110 is constituted as, for example, a substantially rectangular parallelepiped-shape box.
An inside of the vaporizing apparatus 110 acts, for example, as a vaporizing space to heat a solid source S of boron, and evaporate the same.
The solid source S is so constituted that the surface area is enlarged as much as possible, and a hole processing or a groove processing, etc., has been given so that a vapor can be easily taken out.
At the bottom portion of the vaporizing apparatus 110, a solid source fixing plate 111 to which the solid source S is fixed is provided.
At the solid source fixing plate 111, a concave portion 112 to which the solid source S is to be fitted is formed.
In addition, at the solid source fixing plate 111, slit nozzles 113 which are jetting holes to jet a gas G generated by evaporating the solid source S onto a work W which is, for example, a silicon substrate, are formed.
Moreover, to the vaporizing apparatus 110, cooling water passages 114 through which cooling water is passed is provided. The cooling water passages 114 are located between a reflector 123 mentioned below and an outer wall of the vaporizing apparatus 110, and is arranged almost in parallel to halogen valves 121 mentioned below.

The heating device 120 is constituted by halogen valves 121, quartz tubes 122, reflectors 123, cooling gas connection ports 124, etc.
The halogen valves 121 are each formed to a cylindrical shape, and, for example, three valves are so arranged that they are in parallel to the horizontal direction.
Both end portions of the halogen valves 121 are supported by lamp sockets provided at the wall surface of the vaporizing apparatus 110.
The quartz tubes 122 are each formed to a cylindrical shape, and the halogen valves 121 are inserted into the inside diameter side thereof to be substantially concentric with the same.
The quartz tubes 122 are to prevent from excessive temperature rise by irradiation of a long period of time.
The reflectors 123 are reflecting plates located at the upper and the side of the three quartz tubes 122, and upper surface portions are formed to be curved surface shapes surrounding the respective quartz tubes 122.
The cooling gas connection ports 124 are so provided that they are projected from the quartz tubes 122 to the upper directions, and are to introduce a cooling gas into the insides of the quartz tubes 122 to cool the halogen valves 121, and to discharge the same.
The cooling gas may be used, for example, N₂.
The cooling gas connection ports 124 are each provided at the both end portion of the quartz tubes 122.

The discharging device 130 is a passage to recover the excess gas G after jetting to the work W at the peripheral of the bottom of the vaporizing apparatus 110 and discharge the same.

In the first embodiment, the gas G which is a vapor in which the solid source S is absorbed an emission wavelength of the halogen valves 121 to generate a heat and evaporated, is jetted to the work W which passes several millimeters underside the slit nozzles 113, with the carrier gas introduced therein from a carrier gas connection port not shown in the drawing, thereafter they are recovered from the discharging device 130.
At this time, the jetted vapor is fixed on the surface of the work W as a film by contacting with a substrate which has a lower temperature than the vapor temperature atmosphere. At this time, the work W is preheated to prevent from damage due to abrupt temperature change, and the film can be efficiently formed by the preheating.

In the following, Examples of silicon substrates in which boron oxide is formed as a film by the film forming device of the present embodiment are explained.

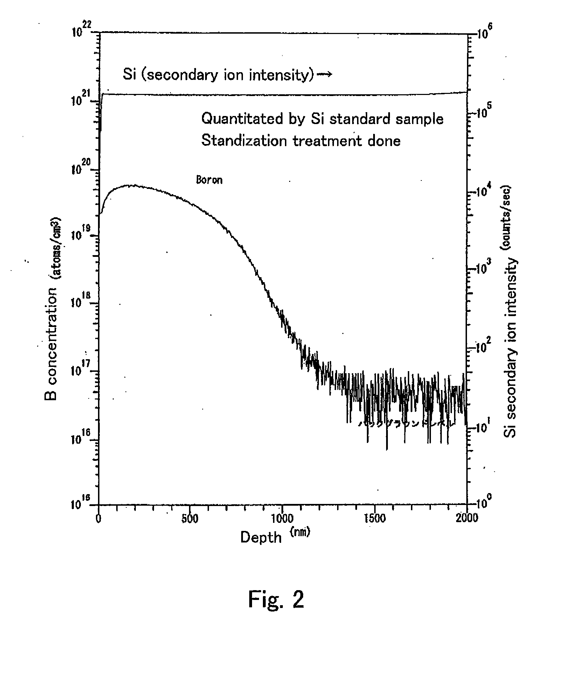

Fig. 2 is a graph showing SIMS profile data of Example 1.
In Example 1, solid boron is heated to 700°C and vaporized to form a boron oxide film on the surface of the silicon substrate, and diffusion is carried out at 1100°C without a cap oxide film.
As shown in Fig. 2, it is possible to diffuse the boron with a concentration of 1 × 10¹⁹/cm³ to a depth direction of up to 0.7 µm.

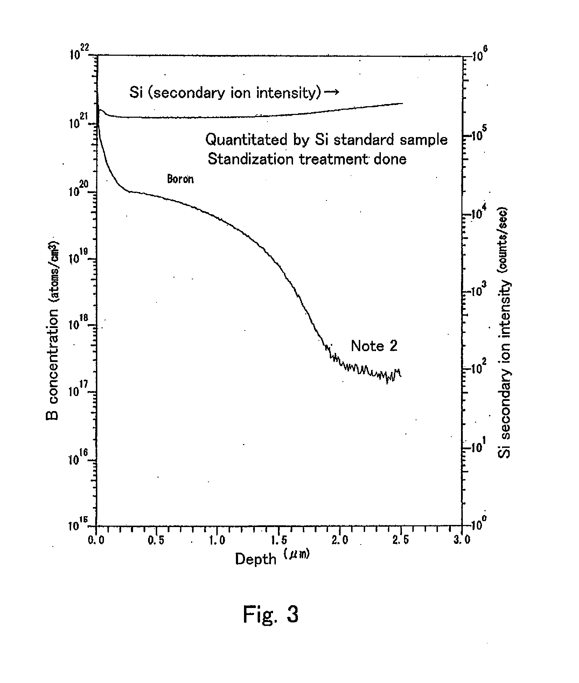

Fig. 3 is a graph showing SIMS profile data of Example 2.
In Example 2, after film forming under the same conditions as in Example 1, a cap oxide film comprising SiO₂ with a thickness of about 100 nm is further formed and then diffusion is carried out at 1100°C.
As shown in Fig. 3, in Example 2, it is possible to diffuse the boron with a concentration of 1 × 10¹⁹/cm³ to a depth direction of up to 1.5 µm.

### <Second embodiment>

Next, a second embodiment of a film forming device to which the present invention has been applied is explained.
Incidentally, the substantially common portions with the previous embodiment are applied to the same reference numerals and duplicate explanation is omitted, and the different points are mainly explained.

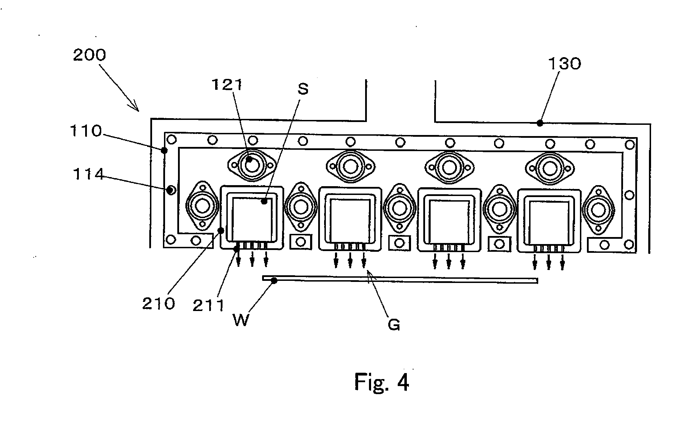

Fig. 4 is a drawing showing the constitution of the second embodiment of the film forming device.

In the film forming device 200 of the second embodiment, the solid sources S are contained at the inside of the pipes 210 and heated by the halogen valves 121 from the outside of the pipes 210. And it is so constituted that the gas G containing a generated vapor and a carrier gas is jetting from slit nozzles 211 formed at the bottom portions of the pipes 210 to the work W.
The pipes 210 are formed by a material which absorbs emission wavelength of the halogen valves 121, is easy to heat and has heat resistance, for example, carbon, or SiC.
The pipes 210 are formed to, for example, rectangular shapes in the sectional surface, and the slit nozzles 211 are formed at the bottom surface thereof.
The pipes 210 are, for example, so arranged that four pipes are in parallel to the horizontal direction, and the halogen valves 121 are arranged opposing to the upper surface and the side surface thereof.
Incidentally, the material and the shape, etc., of the pipes 210 are not limited to the above, and may be optionally changed.
The bottom portions of the pipes 210 are exposed from the openings formed at the bottom surfaces of the vaporizing apparatuses 110 to the work W side.
The pipes 210 each have an introducing port of the carrier gas not shown in the drawing.
In the second embodiment as explained above, substantially the same effects as the effects of the above-mentioned first embodiment can be obtained.

### <Third embodiment>

Next, a third embodiment of a film forming device to which the present invention has been applied is explained.

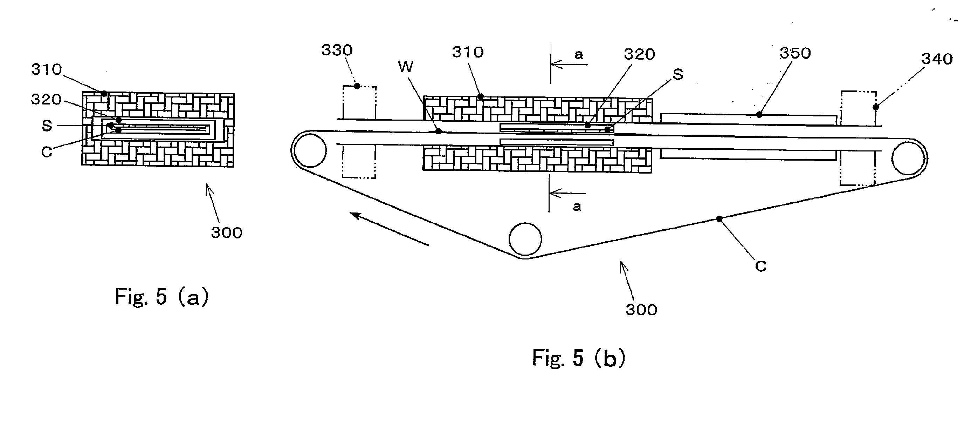

Fig. 5 is a drawing showing the constitution of the third embodiment of the film forming device.
The film forming device 300 of the third embodiment comprises the constitution that a pipe 320 to which a solid source S is fixed is mounted at the inside of a cylindrical heat diffusion furnace 310 through which a work W conveying by a conveyer C is passed, and film formation and diffusion can be carried out simultaneously and continuously by passing the work W through the inside of the pipe 320.
Also, at an entrance side and a discharge side of the heat diffusion furnace 310, a purge chamber at the entrance side 330 and a purge chamber at the discharge side 340 are provided, respectively.
Further, a substrate cooling portion 350 is provided between the heat diffusion furnace 310 and the purge chamber at the discharge side 340.
In the third embodiment as explained above, it is possible to simplify the manufacturing process by carrying out the film formation and diffusion simultaneously and continuously.

### <Fourth embodiment>

Next, a fourth embodiment of a film forming device to which the present invention has been applied is explained.
The film forming device of the fourth embodiment is a device unit which is capable of realizing an atmosphere at 350°C or higher under oxygen atmosphere, to efficiently take out boron from the solid source S heated by the halogen valves.

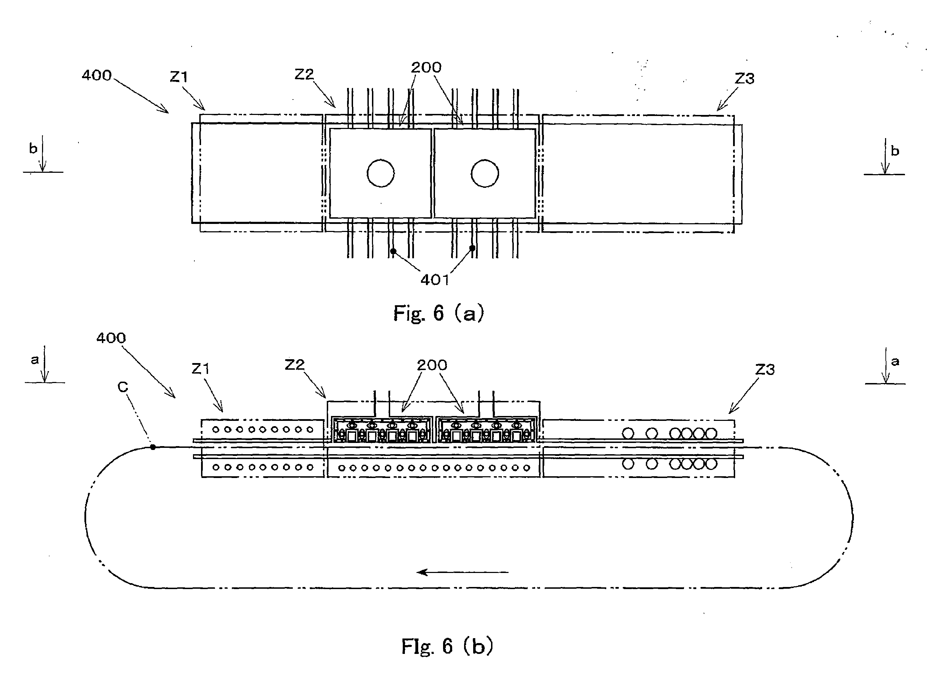

Fig. 6 is a drawing showing the constitution of the fourth embodiment of the film forming device.
As shown in Fig. 6, the film forming device 400 of the fourth embodiment is provided a preheating zone Z1, a film forming zone Z2, and a cooling zone Z3 in this order to the conveying route of the conveyer C.
The film forming zone Z2 is provided, for example, two devices of the film forming devices 200 which are the same as those of the second embodiment along with the conveying direction of the conveyer C.
At the side surface portion of the film forming device 200, an introducing port 410 of a carrier gas is provided.

### (Modified example)

The present invention is not limited to Examples explained above, and various modification or change can be made, and these are also within the technical scope of the present invention.
(1) Each embodiment is used for the manufacture of a P type junction using boron as a solid source, and the present invention can be also used for the manufacture of an N type junction using phosphorus pentaoxide, etc., as a solid source.
(2) Structures and constitution of the film forming device, a shape and a configuration of the respective members are not limited to the above-mentioned respective embodiments, and can be optionally changed.
(3) The film forming conditions of the respective Examples mentioned above are one of the examples, and these can be optionally changed.

**EXPLANATION OF REFERENCE NUMERALS**

| | | | |
|---|---|---|---|
| 100 | Film forming device | 110 | Vaporizing apparatus |
| 111 | Solid source fixing plate | 112 | Concave portion |
| 113 | Slit nozzle | 114 | Cooling water passage |
| 120 | Heating device | 121 | Halogen valve |
| 122 | Quartz tube | 123 | Reflector |
| 124 | Cooling gas connection port | 130 | Discharging device |
| S | Solid source | W | Work (substrate) |
| 200 | Film forming device | 210 | Pipe |
| 211 | Slit nozzle | | |
| 300 | Film forming device | 310 | Heat diffusion furnace |
| 320 | Pipe | 330 | Purge chamber at entrance side |
| 340 | Purge chamber at discharge side | 350 | Substrate cooling portion |
| 400 | Film forming device | 410 | Introducing port |
| Z1 | Preheating zone | Z2 | Film forming zone |
| Z3 | Cooling zone | | |

## Claims

1. A film forming method which comprises
heating a solid source of an impurity and vaporizing the same to generate a gas, and
jetting the gas to a substrate whereby forming a film containing the impurity on the substrate.

2. The film forming method according to Claim 1, wherein
the substrate is preheated before jetting the gas.

3. The film forming method according to Claim 1 or Claim 2, wherein
the solid source is located in an apparatus having injection holes, and
the gas generated by heating the solid source in the apparatus is jetted from the injection holes onto the substrate.

4. The film forming method according to Claim 3, wherein
a carrier gas for carrying the gas into the apparatus is introduced, and the gas is jetted from the injection holes with the carrier gas.

5. The film forming method according to any one of Claim 1 to Claim 4, wherein
the gas is jetted onto the substrate which is continuously conveyed by a conveying apparatus.

6. The film forming method according to any one of Claim 1 to Claim 5, wherein
diffusion of the impurity into the substrate is carried out by utilizing a temperature of the gas simultaneously with the formation of the film.

7. The film forming method according to any one of Claim 1 to Claim 6, wherein the solid source contains boron.

8. The film forming method according to any one of Claim 1 to Claim 6, wherein
the solid source contains phosphorus oxide.

9. A film forming device which comprises
a heating means to heat a solid source of an impurity and evaporate the same to generate a gas, and
a jetting means to form a film containing the impurity onto a substrate by jetting the gas onto the substrate.

10. The film forming device according to Claim 9, wherein
the device has a preheating means to preheat the substrate before jetting the gas.

11. The film forming device according to Claim 9 or Claim 10, wherein
a container portion for containing the solid source is installed,
the heating means is located at an inside of the container portion, and
the jetting means is jetting holes formed to the container portion.

12. The film forming device according to Claim 11, wherein
a carrier gas introducing means to introduce the carrier gas for carrying the gas into the container portion is installed, and
the injection holes are to jet the gas with the carrier gas.

13. The film forming device according to any one of Claim 9 to Claim 12, wherein the jetting means has a conveying means to continuously convey the substrate.

14. The film forming device according to any one of Claim 9 to Claim 13, wherein
diffusion of the impurity into the substrate is carried out by utilizing a temperature of the gas simultaneously with the formation of the film.

15. The film forming device according to any one of Claim 9 to Claim 14, wherein
the solid source contains boron.

16. The film forming device according to any one of Claim 9 to Claim 14, wherein
the solid source contains phosphorus oxide.
